# EUROPEAN PATENT SPECIFICATION

(11) **EP 2 210 338 B1**
(45) Date of publication and mention of the grant of the patent: **01.08.2012**
(21) Application number: 08847748.4
(22) Date of filing: 28.10.2008
(51) Int. Cl.: H03D 7/16

(54) **MIXER ARCHITECTURE**
MISCHERARCHITEKTUR
ARCHITECTURE DE MÉLANGEUR

(30) Priority: 05.11.2007 EP 07119979
(43) Date of publication of application: 28.07.2010
(73) Proprietor: NXP B.V., 5656 AG Eindhoven (NL)
(72) Inventor: HESEN, Leonardus, H., M., NL-5656 AG Eindhoven (NL); VAN SINDEREN, Jan, NL-5656 AG Eindhoven (NL)
(74) Representative: Krott, Michel
(86) International application number: PCT/IB2008/054444
(87) International publication number: WO 2009/060337

(56) References cited:
- EP-A- 1 300 956
- WO-A-00/13306
- US-A1- 2003 194 985
- US-A1- 2007 019 117

## Description

### FIELD OF THE INVENTION

This invention relates to a device, a method and a system for a mixer architecture.

### BACKGROUND OF THE INVENTION

One of the main problems in a multi-standard or multi band receiver is that there are different design constrains for each frequency band. Depending on the standard or application there can be a need for channel filtering.

A wideband receiver that supports multiple standard and or multiple applications could be realized by placing a wideband low noise amplifier (LNA) in front of a metal oxide semiconductor (MOS) passive mixer. But in general this type of wideband receiver needs a very linear radio frequency (RF) front-end which is not feasible or not practical in a lot of applications. This especially holds for low power or portable applications.

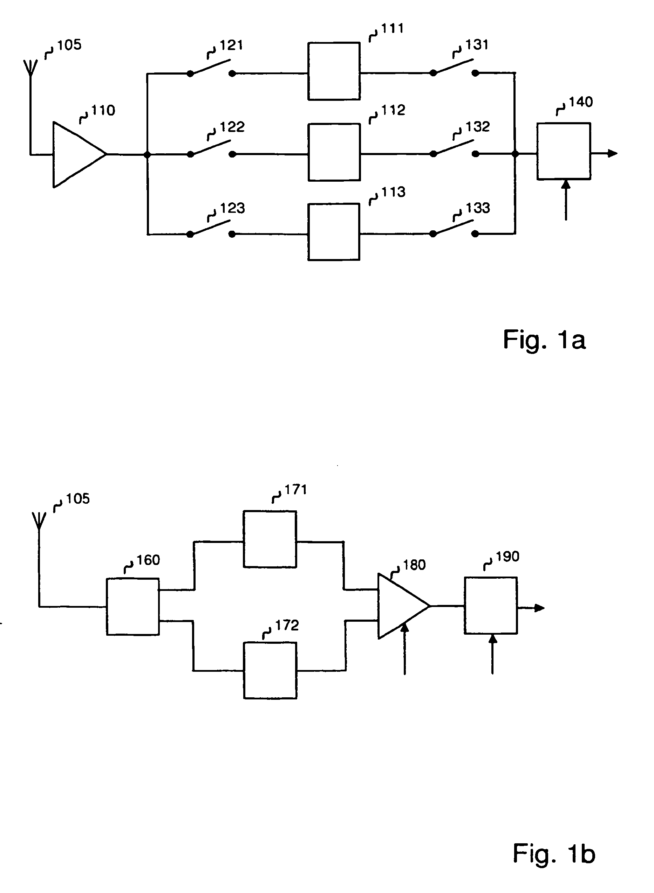

Another practical approach for a wideband receiver is by using switches 121,122,123,131,132,133 to select dedicated RF filtering 111,112,113 in front of the mixer 140, as depicted in Fig. 1a. The amplifier 110 receives the signal from antenna 105 and must represent a wideband low noise amplifier 110 for amplifying the broadcast signals of all frequency bands. Accordingly, the demands made to the design of amplifier 110, e.g. concerning linearity matching, noise and frequency, are very high due to wide frequency range to be covered.

Furthermore, the use of RF switches 121,122,123,131,132,133 may result in excessive front end loss which can degrade receiver sensitivity and/or can cause intermodulation distortion.

Another multiband receiver structure is shown in Fig. 1b, wherein the antenna 105 is coupled to two filters 171,172 via coupling element 160. The amplifier 180 is switchable in order to select one out of the two bands associated with the two filters 171,172.

The mixer 190 is connected to the output of the switchable amplifier 180.

This solution depicted in Fig. 1b shows the same drawback like the receiver structure of Fig. 1a that the common mixer 140,190 must be designed for the most demanded receiver chain with respect to linearity, matching, noise, frequency etc. Thus, not the most optimum receiver per band or application can be realized.

Furthermore, the solutions depicted in Figs. 1a and 1b shows the disadvantage that the common mixer 140,190 or the RF switching core can not be optimized for all possible conditions.

US A-2003-194985 discloses a low noise converter incorporated in a receiver of an antenna for satellite signal transmission/reception, converting two input signals differing in polarization into signals of different intermediate frequencies for transmission to an indoor receiver. Each intermediate frequency band is selected such that no harmonic component of the frequency difference between local oscillation signals is present in the frequency band of each intermediate frequency signal output from each mixer and in the reception band of polarization signals applied to input terminals.

### SUMMARY OF THE INVENTION

According to a first aspect of the present invention, a device is provided as specified in claim 1.

According to a second aspect of the present invention, a method is claimed as defined in claim 14.

According to a third aspect of the present invention, a system is provided as specified in claim 15.

A first mixer unit of said at least two mixer units is associated with a first mixer frequency so that an input signal received at the first input of said first mixer units is mixed with said first mixer frequency. This first mixer frequency may be provided by a corresponding local oscillating signal fed to a second input of the first mixer unit, or, for example, this first mixer frequency may be generated by a frequency synthesizer within the first mixer unit.

The first mixer unit further comprises an output configured to provide at least one output signal in response to said at least one input signal and the first mixer frequency.

A second mixer unit of said at least two mixer units is associated with a second mixer frequency so that an input signal received at the first input of said second mixer unit is mixed with said second mixer frequency. The explanations concerning the first mixer unit mentioned above also hold for the second mixer unit, i.e. the output of the second mixer units is configured to provide at least one output signal in response to the at least one input signal at the first input and the second mixer frequency. The same holds for any further mixer unit.

Each of the at least two mixer units may represent any well-suited mixer configuration. For instance, said mixer configuration may represent a single or balanced mixer, image rejection mixer, harmonic rejection mixer, etc. Furthermore, also different mixer configurations may be used for the at least two mixer units.

The at least one input signal received at any of the first inputs of said at least two mixer units may represent at least one radio frequency (RF) signal. Said at least one input signal may be coupled from said radio frequency unit, which may comprise at least one antenna and other RF components. For instance, said first mixer frequency may be chosen in order to mix a received RF signal into an intermediate frequency (IF) output signal at the output of the first mixer unit.

The second mixer frequency differs from the first mixer frequency. For instance, each of said first and second mixer frequencies may be associated with a different radio frequency band. Thus, the device may be used in a multi-standard or multi band receiver or for different applications. Furthermore, the first and second mixer frequencies may be chosen in such a way that a first RF signal at the first input of the first mixer unit, which is associated with a first RF band, may be mixed by the first mixer unit to the substantially same IF band as a second RF signal at the first input of the second mixer unit, wherein said second RF signal is associated with a second RF band.

For instance, any of the at least two different mixer frequencies may be chosen so that the respective mixer unit, which may be associated with a special RF band, downconverts a received RF signal into the substantially same IF domain.

Each of said at least one amplifier is coupled to at least two outputs of at least two different mixer units of said at least two mixer units. Accordingly, said at least one amplifier may be denoted as a at least one common amplifier, wherein each of said at least one common amplifier is coupled to at least two different mixer units.

For instance, the output of the first mixer unit and the output of the second mixer unit are both coupled to one common amplifier of said at least two amplifiers. A bus is used to connect the outputs of at least two mixer units to said at least one amplifier, so that each of said at least one amplifier is coupled to at least two outputs of at least two different mixer units of said at least two mixer units.

For instance, a plurality of different frequency bands to be received may be covered by means of the plurality of at least two mixer units connected to said at least one amplifier.

The device according to the present invention shows the advantage that each mixer unit of said at least two mixer units can be optimized for a respective frequency band and that said at least one amplifier may be optimized for the substantially same IF band.

Thus, for instance, any receiver chain comprising one mixer unit of said at least mixer units and said at least one common amplifier can be optimized for the respective frequency band or application, although only at least one common amplifier is used.

Accordingly, the device according to the present invention allows that each band can be optimized for performance and power consumption.

Furthermore, for example, said at least one amplifier may operate at zero IF (ZIF) or low IF where the input behaves as a virtual ground. Thus, there are no high frequency restrictions for the wiring between the mixer units and the at least one amplifier so that no degradation on the signal performance is expected, when sharing multiple mixer units.

For instance, the at least one input signal at the first input of the first mixer unit may be equal to the at least one input signal at the first input of at least one further mixer unit. E.g., a common multi-band or wideband antenna may be connectable to said at least two first inputs in order to provide a wideband RF signal.

On the other hand, for instance, the first input of the first mixer unit may be connectable to a first antenna or any other element providing a first RF signal, and the first input of at least one further mixer unit may be connectable to at least one further antenna or any other element providing at least one further RF signal. This shows the advantage, that each of said antennas or RF elements may be optimized for a respective RF band associated with the respective mixer unit.

For instance, each of the at least two mixer units may be configured to be enabled and disabled. Thus, a desired mixer unit out of the at least two mixer units corresponding to a desired frequency band can be enabled, whereas the remaining mixer units can be disabled. Accordingly, the device can be used for a multi-band or multi band receiver or for different applications configured to process different input frequencies.

Furthermore, as an exemplary alternative, the selection of a desired frequency band may also be achieved by switching the corresponding input of the respective desired mixer unit on and switching the remaining inputs of the other mixer units off.

For instance, said at least one mixer unit may be configured to output real signals or complex signals, e.g. the I- und Q-components of a complex signal representation.

Said at least one transimpedance amplifier may exhibit a low input and a low ouput impedance and may be used to decouple said at least two mixer units from an electronic circuit placed behind said at least one amplifier. Any well suited negative feedback amplifier that realize a low ohmic input may be used for a realization of said at least one transimpedance amplifier.

The device comprises a bus in order to couple said at least one amplifier to said at least two outputs of said at least two mixer units. Said bus may comprise at least one wiring line. Said bus may be part of a core of said device, so that further mixer units may be connected to said bus.

Further, said bus comprises a low-pass filter unit. This low-pass filter unit is coupled to the bus or wiring in order to filter unwanted or high frequency signals. For instance, this filter unit may be connected between the bus and ground, but any other suited arrangement may also be used. As an example, at least one capacitor connected between the wiring of the bus and ground may be used as low-pass filter

Said amplifier representing a transimpedance amplifier, said low-pass filter unit makes sure that substantially all high-frequency currents injected to the virtual ground nodes are filtered out and not converted into voltages. (See also detailed part).

This filtering may allow splitting the design of the input structure comprising the mixer units and the design of the at least one amplifier. The input structure may now be optimized for operation at very high frequency, while the amplifier can be designed for intermediate or low frequency operation.

According to an embodiment of the present invention, at least one of said at least two mixer units is configured to be enabled and disabled.

For instance, said device may be coupled to a control logic in order to enable one of said at least two mixer units in accordance with a desired frequency band to be received and downconverted.

Furthermore, there are no restrictions that exactly one mixer units has to be enabled and the remaining mixer units have to disabled. For instance, two or more mixer units may work in parallel. As an example, in case multiple mixer units are enabled at the same time that have different types, topologies, phases or duty cycles new mixer functions can be realized with extra circuit area. This may lead to less switches and drivers.

According to an embodiment of the present invention, each of said at least two mixer units comprises a second input configured to receive at least one local oscillating signal, and wherein said at least one local oscillating signal is associated with one out of said at least two different mixer frequencies.

For instance, said at least one local oscillating signal associated with one out of said at least two different mixer frequencies may be provided in a multiphase representation to the respective mixer unit, wherein this multiphase representation may depend on the type of fixer unit.

According to an embodiment of the present invention, at least one mixer unit of said at least two mixer units is associated with a driver connected to said second input of said at least one mixer unit, said driver being configured to provide said at least one local oscillating signal to the respective mixer unit.

For instance, a first driver is connected to the second input of a first mixer unit in order to provide at least one local oscillating signal associated with the first mixer frequency.

Furthermore, any further mixer unit may be connected to a further driver via the second input of the respective mixer unit in order to be provided with the respective at least one oscillating signal.

Thus, each of the drivers can be optimized with respect to the corresponding mixer frequency, i.e. to the corresponding local oscillating frequency. For instance, the distance between a driver and the associated mixer unit should be small in order to minimize the effect of wiring capacitance.

This allows pairwise optimization of a mixer unit and the respective driver, since both are associated with the same oscillating frequency.

According to an embodiment of the present invention, said driver is configured to enable and disable the respective mixer unit.

For instance, this disabling and enabling may achieved by static DC drive when dc coupling between the driver and the respective mixer unit is used. Furthermore, for instance, an extra control line between the driver and the respective mixer unit may be used to enable and disable the respective driver, e.g. by means of an ac coupling.

This enabling and disabling of the mixer units by means of the respective drivers shows the advantage that no extra switches are needed to enable and/or disable the mixer units and change its functions from mixer unit to switch. For instance, this allows that two mixer units can be placed parallel with a single RF input without the need for extra switches.

For instance, each of said at least one mixer unit is connected to one driver, wherein said driver is configured to disable and enable the respective mixer unit.

According to an embodiment of the present invention, said driver is connected to the respective mixer unit with a control line in order to enable and disable said mixer unit.

According to an embodiment of the present invention, said driver is coupled to the respective mixer unit via direct or dc-coupling in order to enable and disable said mixer unit.

According to an embodiment of the present invention, the device comprises at least two detection units, wherein each of said detection unit is configured to sense at least one local oscillating signal associated with one mixer unit from said at least two mixer units in order to detect the used mixer unit.

According to an embodiment of the present invention, the device comprises at least one preamplifier connected to at least one input of said first inputs of said at least two mixer units.

For instance, at least one of said at least one preamplifier may be associated with a specific radio frequency band and may be coupled to one out of said at least two mixer units, wherein said one mixer unit is also associated with said specific radio frequency band and is configured to mix received radio frequency signals of said radio frequency band to the IF domain. Thus, said at least one of said at least one preamplifier may represent a narrowband preamplifier. This enables optimizing said narrowband preamplifier for the specific radio frequency band. Furthermore, the use of said narrowband preamplifiers allows simplifying the design of linear preamplifiers compared to wideband preamplifiers.

Furthermore, said at least one of said at least one preamplifier may be placed directly in front of the respective mixer unit. Thus, high-frequency properties can be improved.

For instance, said at least one preamplifier may represent a low noise amplifier (LNA).

According to an embodiment of the present invention, at least one preamplifier of said at least one preamplifier represents a wideband preamplifier and is connected to at least two of said first inputs of said at least two mixer units.

For instance, said at least one preamplifier may be associated with at least two radio frequency bands, and said at least two of said first inputs define a common wideband input of said at least two mixer units.

According to an embodiment of the present invention, the device comprises at least one filter connected to at least one input of said first inputs of said at least two mixer units.

For instance, at least one of said at least one filter may be associated with a specific radio frequency band and may be coupled to one input of said at least two mixer units, wherein said one mixer unit is also associated with said specific radio frequency band and is configured to mix received radio frequency signals of said radio frequency band to the IF domain. Thus, said at least one of said at least one filter can be optimized for said specific radio frequency band.

According to an embodiment of the present invention, at least one of said at least one filter represents a band-pass filter.

For instance, said at least one band-pass filter is associated with a specific radio frequency band, so that a mixer unit connected to said band-pass filter may be provided with filtered RF signal according to the specific radio frequency band. This may reduce interference effects from frequencies out of said specific radio frequency band.

According to an embodiment of the present invention, said at least two mixer units represent mixer units providing complex signal representations having a first and a second component, and wherein said at least one amplifier comprises a first amplifier coupled to at least two outputs associated with said first component of said complex mixer units, and wherein said at least one amplifier comprises a second amplifier coupled to at least two outputs associated with said second component of said complex mixer units.

For instance, said complex signal representation may be a complex IQ-signal representation, wherein the first component may represent the I-component and the second component may represent the Q-component, and wherein each mixer unit has an I-output and a Q-output.

Thus, for instance, in case the outputs of the mixer units are differential outputs configured to output a first output signal and the inverted first output signal, then each mixer unit may be configured to output an I-signal, an inverted I-signal, a Q-signal and an inverted Q-signal.

Accordingly, said first amplifier may be used to amplify the I-representation in the IF domain, wherein this first amplifier is connected to the I-outputs of at least two mixer units. The second amplifier may be used to amplify the Q-representation in the IF domain, wherein this second amplifier is connected to the Q-outputs of at least two mixer units. In this exemplary case, four common bus lines may be needed to drive the first and second amplifiers.

It has to be understood, that any other complex signal representation may be used, and it has to be understood that the signal representation is not limited to differential signals, since any other signal representation may also be used.

According to an embodiment of the present invention, at least one mixer unit of said at least two mixer units represents an image rejection mixer.

For instance, said image rejection mixer may have a double balanced structure, wherein the mixer comprises two inputs configured to receive a high frequency signal and it comprises two outputs configured to output the downconverted signal. The mixer may comprise two further inputs configured to be fed with the local oscillating signal.

This double balanced structure may show the advantage that common-mode dc biasing signals and nonlinearities of the transistors may be cancelled.

According to an embodiment of the present invention, at least one mixer unit of said at least two mixer units represents a harmonic rejection mixer.

Depending on the desired frequency band the harmonic rejection mixer may be selected in order to avoid RF signal mixing with unwanted local oscillating harmonics.

Furthermore, a combination of at least one image rejection mixer and/or at least one harmonic rejection mixer and/or at least one other mixer may be used for a realization of said at least two mixer units.

According to an embodiment of the present invention, at least one amplifier parameter of at least one of said at least one amplifier is adjustable.

This at least one adjustable amplifier parameter may be used to compensate for different characteristics of different mixer units and the connected topology of wiring which may be caused by the different mixer types and/or to comply with different channel bandwidths or other variable characteristics dependent on the chosen band, wherein said different characteristics may occur when it is switched between the different mixer units. For instance, the gain, the filter characterstic or other parameters could be changed depending on the requirements when it is switched between the different mixer units.

For instance, said adjustable amplifier parameter may be realized by means of at least one adjustable feedback resistor and/or capacitor

According to an embodiment of the present invention, said at least one input signal represents a radio frequency signal and said at least two different mixer frequencies are associated with at least two frequency bands of a multi-band receiver.

For instance, the present invention may be used for any multi-band or multi standard receiver. E.g., it may be used for realizing a full performance single chip silicon front end for digital TV reception on mobile and portable devices.

According to an embodiment of the present invention, said at least two mixer units represent downconverter mixer units, and said at least one amplifier represents an intermediate frequency (IF) amplifier.

Thus, for instance, this may show the advantage that each mixer unit can be optimized for a respective frequency band and that the at least one amplifier may be optimized for the substantially same IF band Hence, each receiver chain comprising a mixer unit and the amplifier can be optimized for the respective frequency band or application, although the at least one common amplifier is used. Accordingly, the present invention allows that each band can be optimized for performance and power consumption.

Furthermore, for instance, when the feedback network in the at least one amplifier is programmable by means of said at least one adjustable feedback capacitor, then said at least one amplifier may be adjustable to different IF bands. Thus, the present invention could also be used for multi-standards which could require a different filter transfer.

Furthermore, said at least one amplifier may operate at zero IF (ZIF) or low IF where the input behaves as a virtual ground. Thus, there are no high frequency restrictions for the wiring between the mixer units and the amplifier so that no degradation on the signal performance is expected, when sharing multiple mixer units.

These and other aspects of the invention will be apparent from and elucidated with reference to the detailed description presented hereinafter. The features of the present invention and of its exemplary embodiments as presented above are understood to be disclosed also in all possible combinations with each other.

### BRIEF DESCRIPTION OF THE FIGURES

In the figures show:
Fig. 1a: An illustration of a prior art device;
Fig. 1b: An illustration of a further prior art device;
Fig. 2a: An illustration of a first exemplary embodiment of a device according to the present invention;
Fig. 2b: An illustration of a second exemplary embodiment of a device according to the present invention;
Fig. 3a: An illustration of an exemplary mixer configured to be used by the present invention;
Fig. 3b: An illustration of an exemplary amplifier configured to be used by the present invention;
Fig. 4a: An illustration of a third exemplary embodiment of a device according to the present invention;
Fig. 4b: An illustration of a modified third exemplary embodiment of a device according to the present invention;
Fig. 5a: An illustration of a fourth exemplary embodiment of a device according to the present invention;
Fig. 5b: An illustration of a fifth exemplary embodiment of a device according to the present invention;
Fig. 6a: An illustration of a sixth exemplary embodiment of a device according to the present invention;
Fig. 6b: An illustration of a seventh exemplary embodiment of a device according to the present invention;
Fig. 6c: An illustration of an eighth exemplary embodiment of a device according to the present invention;
Fig. 7: An illustration of a flowchart of an exemplary method according to the present invention.

### DETAILED DESCRIPTION OF THE INVENTION

In the following detailed description of the present invention, exemplary embodiments of the present invention will be described in the context of mixer architectures.

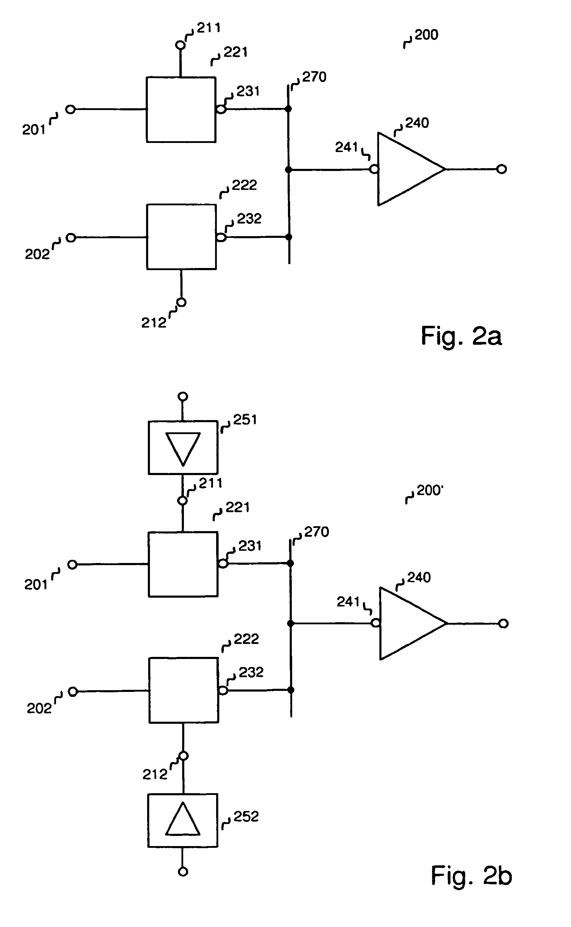

Fig. 2a depicts a first exemplary embodiment of a device 200 according to the present invention.

The device 200 comprises a first mixer unit 221 and a second mixer unit 222. Each of the first mixer unit 221 and the second mixer unit 222 comprises an input 201,202 configured to receive at least one input signal.

The first mixer unit 221 is associated with a first mixer frequency so that an input signal received at first input 201 is mixed with said first mixer frequency. This first mixer frequency may be provided by a corresponding local oscillating signal fed to second input 211 of the first mixer unit 221 or, for example, this first mixer frequency may be generated by a frequency synthesizer within the first mixer unit 221 (not depicted in Fig. 2a). The first mixer unit 221 further comprises an output 231 configured to provide at least one output signal in response to said at least one input signal at the first input 201 and the first mixer frequency.

Each of the first and second mixer units 221,222 may represent any well-suited mixer configuration. For instance, said mixer configuration may represent a single or balanced mixer, Image Rejection mixer, Harmonic Rejection mixer, etc. Furthermore, also different mixer configurations may be used for the mixer units 221,222.

The at least one input signal received at the first input 201 may represent at least one Radio Frequency (RF) signal. For instance, said first mixer frequency may be chosen in order to mix a received RF signal into an intermediate frequency (IF) output signal at output 231 of the first mixer unit 221.

The second mixer unit 222 is associated with a second mixer frequency so that an input signal received at first input 202 is mixed with said second mixer frequency. The explanations concerning the first mixer unit 221 mentioned above also hold for the second mixer unit 222, i.e. output 232 is configured to provide at least one output signal in response to the at least one input signal at input 202 and the second mixer frequency. Optional, the second mixer unit 222 may comprise a second input 212 in order to receive a local oscillating signal corresponding to the second mixer frequency.

The second mixer frequency differs from the first mixer frequency. For instance, each of said first and second mixer frequency may be associated with a different radio frequency band. Thus, the device 200 may be used in a multi-standard or multi band receiver or for different applications. Furthermore, the first and second mixer frequencies may be chosen in such a way that a first RF signal at input 201 associated with a first RF band may be mixed by mixer unit 221 to the substantially same IF band as a second RF signal at input 202 associated with a second RF band.

The output 231 of the first mixer unit 221 and the output 232 of the second mixer unit 222 are coupled to the input 241 of the amplifier 240. Thus, the amplifier 240 is coupled to at least two outputs 231,232 of two different mixer units 221,222. Accordingly, the amplifier 240 may be denoted as a common amplifier 240 being both coupled to the first mixer unit 221 and to the second mixer unit 222.

As exemplarily depicted in Fig. 2a, a bus or wiring 270 may be used to connect the outputs 231,232 of the mixer units 221,222 to the amplifier 240. This first exemplary embodiment shown in Fig. 2a comprises only a first and a second mixer unit 221,222, but there may be connected more than two mixer units to the bus or wiring 270.

Thus, for instance, a plurality of different frequency bands to be received may be covered by means of the plurality of at least two mixer units 221,222 connected to the amplifier 240 via the bus 270.

Further, for instance, the device 200 may show the advantage that each mixer unit 221,222 can be optimized for a respective frequency band and that the common amplifier 240 may be optimized for the substantially same IF band. Thus, both the first receiver chain comprising the first mixer unit 221 and the amplifier 240 and the second receiver chain comprising the second mixer unit 222 and the amplifier 240 can be optimized for the respective frequency band or application, although only one common amplifier 240 is used. Accordingly, the device 200 according to the present invention allows that each band can be optimized for performance and power consumption, wherein the demands of each mixer unit 221,222 concerning linearity, impedance, matching, noise and frequency are decreased compared to wide frequency mixers.

Furthermore, for example, said amplifier 240 may operate at zero IF (ZIF) or low IF where the input behaves as a virtual ground. Thus, there are no high frequency restrictions for the wiring 270 between the mixer units 221,222 and the amplifier 240 so that no degradation on the signal performance is expected, when sharing multiple mixer units 221,222.

The device 200 may comprise a low-pass filter unit (not depicted in Fig. 2a) coupled to the bus or wiring 270 in order to filter unwanted or high frequency signals. For instance, this low-pass filter unit may be connected between the bus or wiring 270 and ground, but any other suited arrangement may also be used. As an example, at least one capacitor connected between the bus or wiring 270 and ground may be used as low-pass filter. Said amplifier representing a transimpedance amplifier 240, said at least one capacitor makes sure that substantially all high-frequency currents injected to the virtual ground nodes are filtered out and not converted into voltages.

This low-pass filtering between the mixer units 221,222 and the and the design of the amplifier 240 may improve the performance and may allow splitting the design of the input structure comprising the mixer units 221,222 and the design of the amplifier 240. The input structure may now be optimized for operation at very high frequency, while the amplifier 240 can be designed for intermediate or low frequency operation.

For instance, the at least one input signal at input 201 of the first mixer unit 221 may be equal to the at least one input signal at input 202 of the first mixer unit 222. E.g., a common multi-band or wideband LNA or antenna may be connectable to both inputs 201 and 202 in order to provide a wideband RF signal. On the other hand, for instance, the input 201 of the first mixer unit 221 may be connectable to a first antenna (LNA or filter) and the input 202 of the second mixer unit 222 may be connectable to a second antenna (LNA or filter). This shows the advantage, that both the first and second antenna may be optimized for a respective RF band associated with the respective mixer unit.

For instance, each of the first mixer unit 221 and the second mixer unit 222 may be configured to be enabled and disabled. Thus, a desired mixer unit out of the first and second mixer units 221,222 corresponding to a desired frequency band may be enabled, whereas the remaining mixer units can be disabled. Accordingly, the device 200 can be used for a multi-band or multi band receiver or for different applications configured to process different input frequencies.

Furthermore, as an exemplary alternative, the selection of a desired frequency band may also be achieved by switching the corresponding input 201,202 of the respective desired mixer unit on and switching the remaining inputs of the other mixer units off.

Fig. 2b depicts a second exemplary embodiment of a device 200' according to the present invention. This second exemplary embodiment is based on the first exemplary embodiment depicted in Fig. 2a. Accordingly, the explanations and advantages mentioned above with respect to device 200 also hold for the device 200' according to the second exemplary embodiment.

Each of the mixer units 221,222 is associated with an own driver 251,252 for providing the respective mixer frequency. For instance, the first driver 251 is connected to the second input 211 of the first mixer unit 221 in order to provide at least one local oscillating signal associated with the first mixer frequency, and the second driver 252 is connected to the second input 212 of the second mixer unit 222 in order to provide at least one local oscillating signal associated with the second mixer frequency.

Thus, each of the drivers 251,252 can be optimized with respect to the corresponding mixer frequency, i.e. to the corresponding local oscillating frequency. For instance, the distance between the driver 251,252 and the associated mixer unit 221,222 should be small in order to minimize the effect of wiring capacitance.

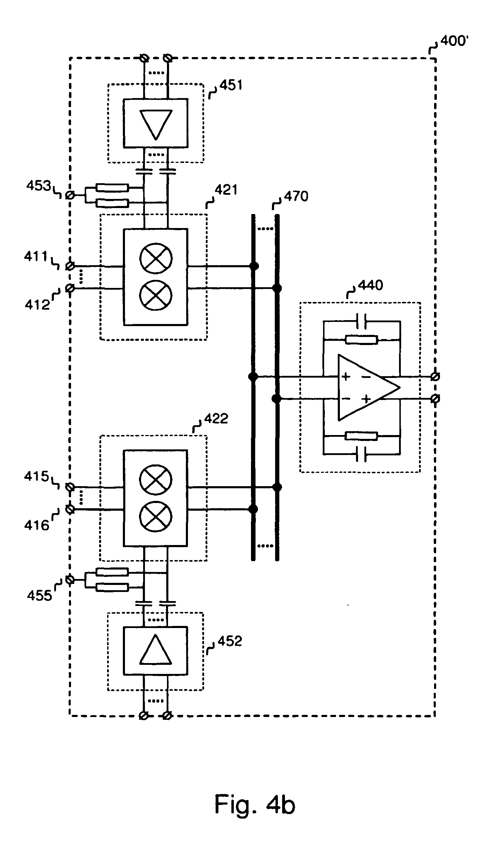

Furthermore, a mixer unit 221,222 may be configured to be disabled and enabled by the respective driver 251,252. For instance, this may be achieved when there is a dc coupling between the driver 251,252 and the respective mixer unit 221,222 and provide a static drive at the input node of driver 251,252 so that the mixer unit is disabled. Furthermore, for instance, an extra high Ohmic control line (not depicted in Fig. 2b) located between the driver 251,252 and the respective mixer unit 221,222 may be used to enable and disable the respective driver 251,252. This way of disabling is necessary in case AC-coupling (a capacitor is placed between the driver and mixer unit) is used between the driver 251,252 and the respective mixer unit 221,222, as exemplarily explained in the modified third embodiment depicted in Fig. 4b.

This enabling and disabling of the mixer units 221,222 by means of the drivers 251,252 shows the advantage that no extra switches are needed to enable and/or disable the mixer units 221,222 and change its functions from mixer unit 221,222 to switch. For instance, this allows that two mixer units 221,222 can be placed parallel with a single RF input without the need for extra switches.

The explanations and advantages given with respect to the first and second exemplary embodiment also hold for the further exemplary embodiments of the present invention.

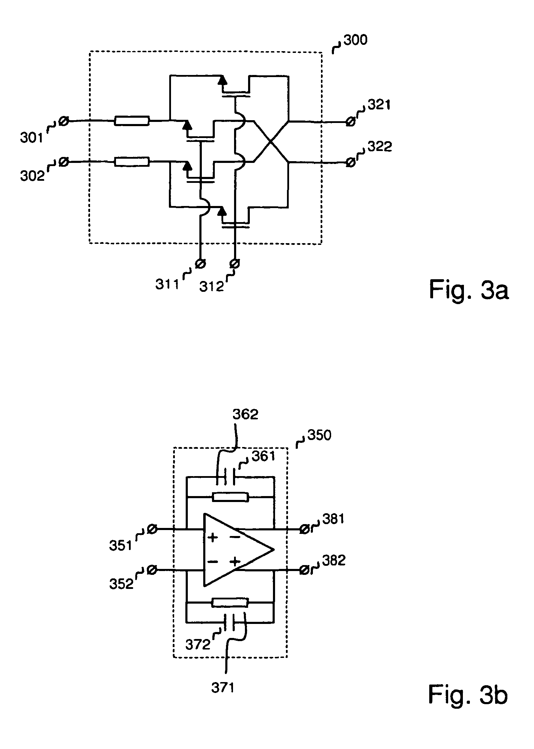

Fig. 3a depicts an illustration of an exemplary mixer 300 configured to be used by the present invention. This mixer 300 represents a double balanced Metal Oxide Semiconductor (MOS) passive downconversion mixer and may be used for any of the mixer units of a device according to the present invention.

According to the double balanced structure, the mixer 300 comprises two inputs 301,302 configured to receive a high frequency signal and it comprises two outputs 321,322 configured to output the downconverted signal. The inputs 311,312 are configured to be fed with the local oscillating signal.

The double balanced structure of mixer 300 shows the advantage that common-mode dc biasing signals and nonlinearities of the transistors may be cancelled.

For instance, a mixer unit according to the present invention may comprise one or a plurality of this mixer 300 depicted in Fig. 3a, but any other suited mixer unit may also be applied.

Fig. 3b depicts an exemplary amplifier 350 configured to be used by the present invention. This amplifier 350 represents a transimpedance amplifier having two inputs 351,352 so that this amplifier 350 may for instance be used for balanced systems. Of course, any other suited transimpedance amplifier may be used for the present invention, e.g. an amplifier with one input or a plurality of inputs. This transimpedance amplifier 350 exhibits a low input impedance and a low output impedance.

The first output 381 is coupled back to the first input by means of at least one feedback element 361,362, wherein this at least one feedback element 361,362, for instance, may represent the resistor 361 and capacitor 362 as depicted in Fig. 3b. The resistor 361 may be used to influence the gain of the amplifier 350 with respect to input 351 and output 381, and the optional capacitor 362 may be used to introduce lowpass filtering. For instance, the resistor 362 may be adjustable in order vary the amplifier gain. Furthermore, for instance, the capacitor 361 may be adjustable in order vary the amplifier bandwidth.

The explanations and advantages given to the at least one feedback element 361,362 associated with the first input 351 and the first output 381 also hold for the at least one feedback element 371,372 associated with the second input 352 and the second output 381.

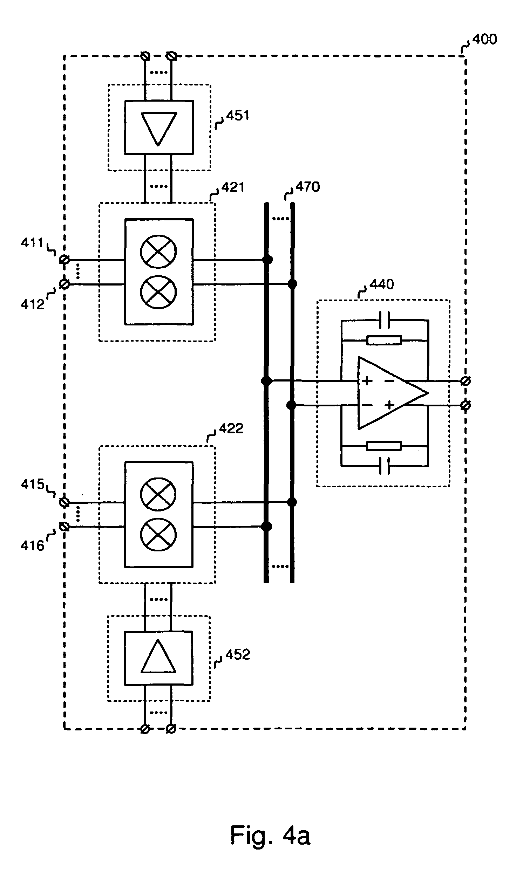

Fig. 4a depicts an illustration of a third exemplary embodiment of a device 400 according to the present invention.

This third exemplary embodiment is based on the second exemplary embodiment depicted in Fig. 2b. The device 400 comprises at least two mixer units 421,422 and an amplifier 440. Each of said at least two mixer units 421,422 comprises at least one mixer, and each of said at least two mixer units 421,422 is configured to receive at least one input signal. For instance, each of said input signals may be represented by a symmetrical signal or a balanced signal, wherein each signal may have a first component and a second component. E.g., the second component may represent the inverted first component. Thus, for instance, a first component of a first radio frequency signal may be coupled to input 411 of the first mixer unit 421 and the inverted first component of said first radio frequency signal may be coupled as second component to input 412. Correspondingly, the inputs 415,416 of the second mixer unit 422 may be configured to receive a first and a second component of a second radio frequency signal to be mixed.

For instance, the mixer 300 depicted in Fig. 3a may be used for said at least two mixer units 421,422, but also any other suited mixer may be applied. Any of the mixer units may be configured to receive more than one input signal to be mixed, as indicated by the dots in Fig. 4a. Accordingly, each of the drivers 451,452 may be configured to provide at least one local oscillating signal to the respective mixer unit 421,422.

Both at least two mixer units 421,422 share the common amplifier 440, wherein the at least two mixer units 421,422 are coupled to amplifier 440 by means of a bus or common IF signal lines 470. The size of the bus or common IF signal lines 470 may depend on the topology of the mixer units 421,422 and the type of signal. For instance, in case the outputs of the mixer units represent complex IQ outputs (not depicted in Fig. 4), then four common bus lines 470 may be needed to drive two IF amplifiers instead of two common bus lines 470 for driving one IF amplifier 440 as shown in Fig. 4.

The amplifier 440 may be realized by means of the amplifier 350 depicted in Fig. 3b, but also any other suited amplifier may be applied.

Furthermore, as explained above with respect to the second embodiment depicted in Fig 2, each of the mixer units 421,422 can be disabled by means of the respective driver 451,452. For instance, in case the mixer 300 depicted in Fig. 3a is used, then this mixer 300 may be disabled by providing a constant and low gate voltage on all gates. The mixer units and drivers that are switched-off consume no power and will not influence the performance of the active mixer chain, i.e. the respective mixer unit and amplifier 440 in the selected band. Since no further switching elements in the signal path are included no performance degradation can be achieved.

It has to be noted, that the present invention allows various combinations with respect to the mixer units 421,422, the common IF signal lines 470, the drivers 451,452 and the amplifier 440 and with respect to other optional elements like additional filter units or low noise amplifiers.

Fig. 4b depicts an illustration of a modified third exemplary embodiment of a device 400' according to the present invention. This modified third exemplary embodiment is based on the third exemplary embodiment illustrated in Fig. 4a. Thus, all explanations of said third exemplary embodiment also hold for this modified third embodiment.

This modified third exemplary embodiment comprises an AC coupling between the driver 451,452 and the respective mixer unit 421,422 by means of the capacitors. An extra high Ohmic control line is located between the driver 451,452 and the respective mixer unit 421,422, wherein each of these control lines comprises an input 453,454 in order to enable and disable the respective mixer unit 421,422. This way of controlling the mixer units 421,422 by means of said control lines may be used for any of the other exemplary embodiments of a device according to the present invention.

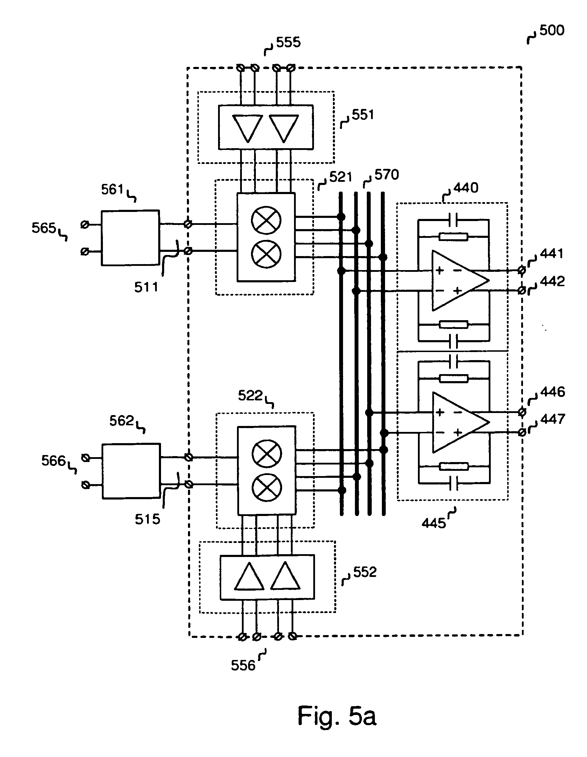

Fig. 5a depicts an illustration of a fourth exemplary embodiment of a device 500 according to the present invention.

The device 500 is based on device 400 depicted in Fig. 4 and is directed to a complex signal representation, so that four common IF signal lines 570 are used to provide the I-signal representations to the first common amplifier 440 and the Q-signal representations to second common amplifier 445. Thus, the first output 441 of the first amplifier 440 outputs the downconverted and amplified I-signal representation in the IF domain and the second output 442 of the first amplifier 440 outputs the dowconverted and amplified inverted I-signal representation in the IF domain. Correspondingly, the first output 446 of the second amplifier 445 outputs the Q-signal representation in the IF domain and the second output 457 of the second amplifier 445 outputs the inverted Q-signal representation in the IF domain.

In order to provide complex IQ-outputs at the mixer units 521,522, each of the drivers 551,552 is provided with four local oscillating signals at their inputs 555,556. The four local oscillating signals at input 555 are associated with the first mixer frequency of the first mixer unit 521, and the four local oscillating signals at input 556 are associated with the second mixer frequency of the second mixer unit 522.

The element 561 connected to the input 511 of the first mixer unit 521 may represent a band-pass filter 561, if there is need for channel filtering, and element 562 connected to the input 515 of the second mixer unit 522 may also represent a band-pass filter 562. For instance, the first band-pass filter 561 may be configured to receive a first RF signal at input 565 and to filter this first RF signal according to a first radio frequency band associated with the first mixer unit 521, and the second band-pass filter 562 may be configured to receive a second RF signal at input 566 and to filter this second RF signal according to a second radio frequency band associated with the second mixer unit 522.

Thus, each radio frequency band can be isolated by means of the band-pass filter 561,562 and the switchable mixer units 521,522. Each band-pass filter 561,562 may be placed directly in front of the respective mixer unit 521,522 which has its own local oscillating driver 551,552.

Furthermore, for instance, at least one of the elements 561,562. may represent a low noise amplifier (LNA) configured to amplify the received RF signal. This at least one LNA may also be placed directly in front of the respective mixer unit 521,522. Thus, said at least one optional LNA 561,562 may represent a narrowband preamplifier. This may enable optimizing said narrowband preamplifier for the specific radio frequency band. Furthermore, the use of said narrowband preamplifiers allows simplifying the design of linear preamplifiers compared to wideband preamplifiers.

The device 500 depicted in Fig. 5a shows a two-band implement of a device according to the present invention, but it has to be understood that more bands can be added when needed. Furthermore, the mixer units 521,522 of device 500 represent image rejection mixers, for instance by using twice (same input but with 90 degree phase shifted signals at the gates) the mixer 300 shown in Fig. 3, but it has to be understood that any other kind of mixer type may be used for said mixer units 521,522. This also holds for the mixer units 421,422 of the third exemplary embodiment depicted in Fig. 4.

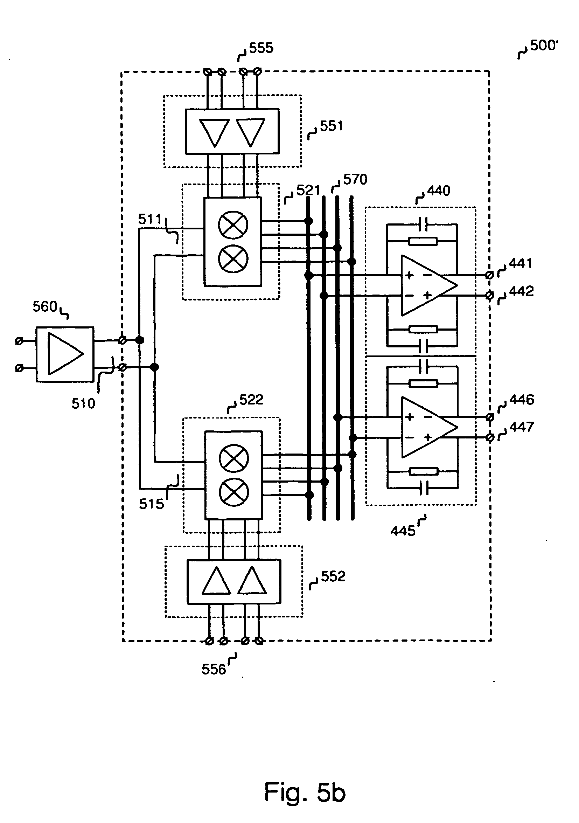

Fig. 5b depicts an illustration of a fifth exemplary embodiment of a device 500' according to the present invention, wherein this device 500' is substantially based on the device 500 according to the fourth exemplary embodiment.

In contrast to the fourth exemplary embodiment, the device 500' comprises a common wideband input 510 for all mixer units 521,522. A LNA 560 configured to receive a RF signal may be connected to the common wideband input 510 so that the first input 511 of the first mixer unit 521 and that the first input 515 of the second mixer unit 522 are both provided with the RF signal.

For instance, said at least two mixer units 521,522 may have different design constraints or parameters compared to that of the fourth exemplary embodiment, but the mixer topology remains substantially the same.

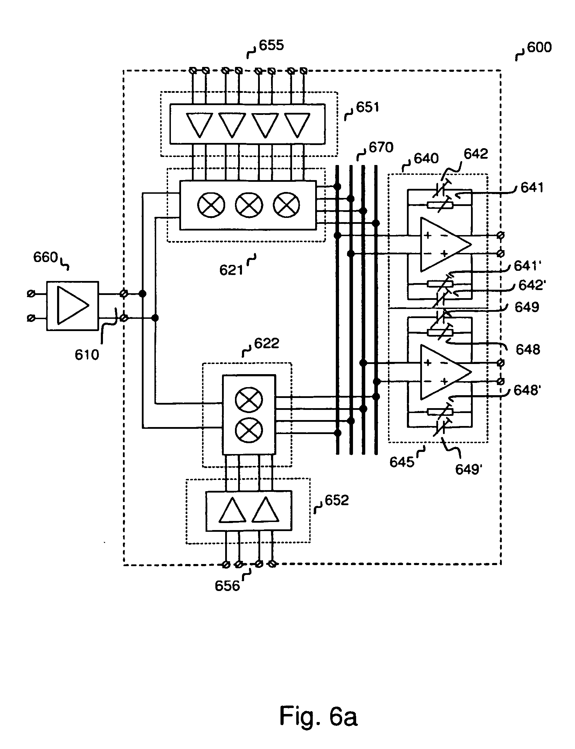

Fig. 6a depicts an illustration of a sixth exemplary embodiment of a device 600 according to the present invention.

In this sixth embodiment the mixer architecture is arranged as a multi-mixer in a wideband receiver similar to the device 500' according to the fifth embodiment. Thus, a common LNA 660 may be coupled to the wideband input 610 of the device 600.

The device 600 comprises different types of mixer units 621,622, wherein the first mixer unit 621 represents a harmonic rejection mixer unit 621 and the second mixer unit 622 represents an image rejection mixer unit 622. The first mixer unit 621 and the second mixer unit 622 may be placed in parallel.

Depending on the desired frequency band the harmonic rejection mixer unit 621 may be selected in order to avoid RF signal mixing with unwanted LO harmonics. The input 655 of the first driver 651 is configured to receive multiphase LO signals for the harmonic rejection mixer units 622. The second driver 652 and its input 656 may be the same as in the fifth embodiment.

Furthermore, the first transimpedance amplifier 640 and/or the second transimpedance amplifier 645 may comprise adjustable feedback resistors 641,641',648,648'. Thus, different characteristics of the first mixer unit 621 and the second mixer unit 622 and/or the topology of wiring 670 due to the different mixer types, which may occur when it is switched between the mixer units 621,622, can be minimized by means of varying the feedback resistance of the IF amplifier 640,641. For instance, the gain or other parameter could be changed depending on the requirements. E.g., the resistors 641,641',648,648' may be variable in steps or constant.

As already mentioned with respect to the preceding embodiments, this sixth exemplary embodiment may also be extended with more and/or different mixer units when needed.

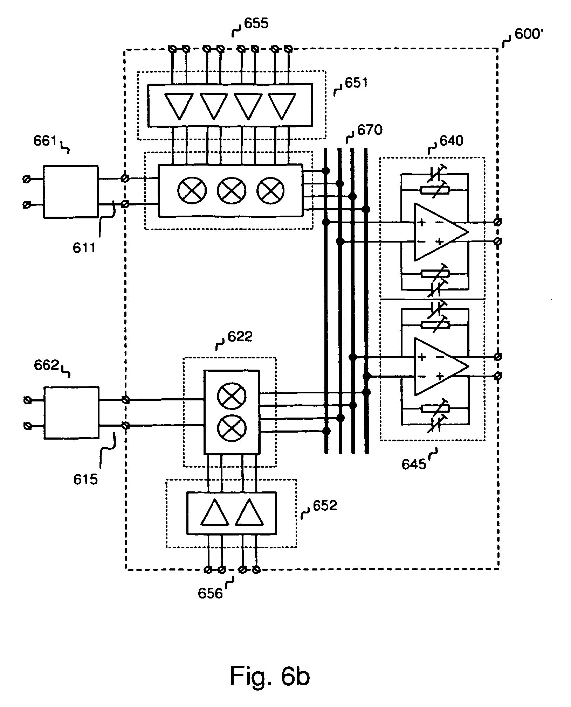

Fig. 6b depicts an illustration of a seventh exemplary embodiment of a device 600' according to the present invention, wherein this seventh exemplary embodiment is substantially based on the sixth exemplary depicted in Fig. 6a and the fourth embodiment depicted in Fig. 5a.

The device 600' comprises multiple inputs 611,615 and multiple RF elements 661,662 similar to elements 561,562 of the fourth embodiment. Thus, the explanations mentioned above with respect to elements 561 and 562 also holds for the RF elements 661 and 662.

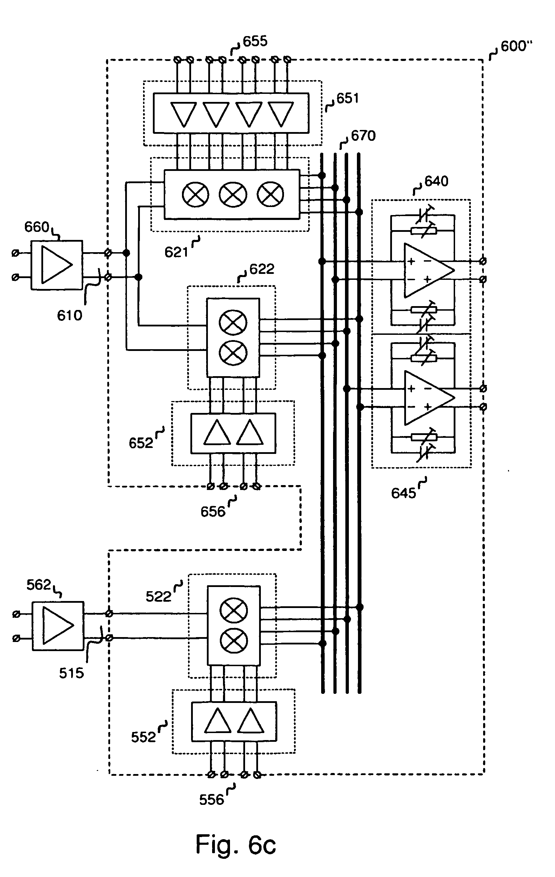

Fig. 6c depicts an illustration of an eighth exemplary embodiment of a device 600" according to the present invention which may represent a combination of the multi-mixer device according to the sixth or seventh embodiment and the fifth embodiment depicted in Fig. 5a.

In this seventh exemplary embodiment three multiple mixer units 621,622,522 are connected to the common amplifier 640,641 via the common IF lines 670. The input 610 is configured to receive RF signals associated with a first and/or a second RF band, wherein the first RF band may be processed by the first mixer unit 621 and the second RF band may be processed by the second mixer unit 622, and the further input 515 is configured to receive an RF signal associated with a third RF band. Thus, one out of the three mixer units 621,622,522 may be enabled in order process and downconvert the corresponding RF band.

It has to be noted, that various combinations of mixer architectures of the preceding exemplary embodiments and variations thereof may be used for further exemplary embodiments according to the present invention.

Furthermore, there are no restrictions that exactly one mixer units has to be enabled and the remaining mixer units have to disabled. For instance, two or more mixer units may work in parallel. As an example, in case multiple mixer units are enabled at the same time that have different types, topologies, phases or duty cycles new mixer functions can be realized without extra circuit area. This may lead to less switches and drivers.

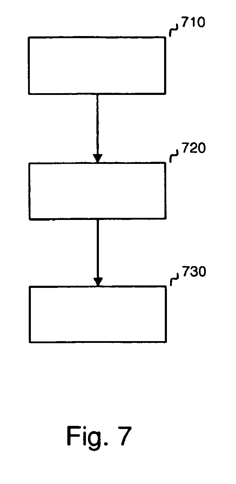

Fig. 7 depicts a flowchart of an exemplary embodiment of a method according to the present invention.

This method may be applied for any of the previous exemplary embodiments according to the present invention.

Optional, in step 710, at least one out of said at least two mixer units is enabled and the remaining mixer units are disabled. For instance, a mixer unit associated with a specific radio frequency band to be received may be enabled, as explained before.

Then, in step 720, the radio frequency signal received at at least one of said at least two mixer units, e.g. at the enabled mixer unit, is mixed to at least one output signal according to the associated mixer frequency.

In step 730, said at least one output signal is amplified by means of said at least one amplifier, wherein each of said at least one amplifier is coupled to at least two outputs of at least two different mixer units of said at least two mixer units.

The invention has been described above by means of exemplary embodiments. It should be noted that there are alternative ways and variations which are obvious to a skilled person in the art and can be implemented without deviating from the scope of the appended claims.

Furthermore, it is readily clear for a skilled person that the logical blocks in the schematic block diagrams as well as the flowchart and algorithm steps presented in the above description may at least partially be implemented in electronic hardware and/or computer software, wherein it depends on the functionality of the logical block, flowchart step and algorithm step and on design constraints imposed on the respective devices to which degree a logical block, a flowchart step or algorithm step is implemented in hardware or software. The presented logical blocks, flowchart steps and algorithm steps may for instance be implemented in one or more digital signal processors, application specific integrated circuits, field programmable gate arrays or other programmable devices. The computer software may be stored in a variety of storage media of electric, magnetic, electro-magnetic or optic type and may be read and executed by a processor, such as for instance a microprocessor. To this end, the processor and the storage medium may be coupled to interchange information, or the storage medium may be included in the processor.

## Claims

1. A device, comprising:
- at least two mixer units (221,222,421,422,521,522,621,622) associated with at least two different mixer frequencies, wherein each of said mixer units (221,222,421,422,521,522,621,622) comprises a first input (201,202,411,412,415,416,511,515) configured to receive at least one input signal to be mixed,
- at least one amplifier (240,440,445,640,645), wherein each of said at least one amplifier (240,440,445,640,645) is coupled to at least two outputs (231,232) of at least two different mixer units (221,222,421,422,521,522,621,622) of said at least two mixer units (221,222,421,422,521,522,621,622), wherein said at least one amplifier (240,440,445,640,645) represents at least one transimpedance amplifier,
- a bus (270,470,570,670) configured to couple said at least one amplifier (240,440,445,640,645) to said at least two outputs of said at least two mixer units (221,222,421,422,521, 522,621,622),
wherein said bus (270,470,570,670) comprises a low-pass filter unit coupled to said bus (270,470,570,670) in order to filter unwanted or high frequency signals by providing a low-pass filtering, said low-pass filter unit ensuring that substantially all high-frequency currents injected to virtual ground nodes are filtered out and not converted into voltages.

2. The device according to claim 1, wherein at least one of said at least two mixer units (221,222,421,422,521,522,621,622) is configured to be enabled and/or disabled.

3. The device according to any one of claims 1-2, wherein each of said at least two mixer units (221,222,421,422,521,522,621,622) comprises a second input (211,212) configured to receive at least one local oscillating signal, and wherein said at least one local oscillating signal is associated with one out of said at least two different mixer frequencies.

4. The device according to claim 3, wherein at least one mixer unit of said at least two mixer units (221,222,421,422,521,522,621,622) is associated with a driver (251,252,451,452,551,552,651,652) connected to said second input (211,212) of said at least one mixer unit (221,222,421,422,521,522,621,622), said driver (251,252,451,452,551,552,651,652) being configured to provide said at least one local oscillating signal to the respective mixer unit (221,222,421,422, 521,522,621,622).

5. The device according to claim 4, wherein said driver (251,252,451,452,551, 52,651,652) is configured to enable and/or disable the respective mixer unit (221,222,421,422,521,522,621,622).

6. The device according to claim 4, wherein said driver (251,252,451,452,551, 552,651,652) is connected to the respective mixer unit (221,222,421,422,521,522,621,622) via an alternating current coupling, and wherein a control line is connected to said alternating current coupling in order to enable and/or disable said mixer unit (221,222,421,422,521,522,621,622).

7. The device according to any one of claims 1-6, comprising at least one preamplifier (560,561,562,660,661,662) connected to at least one input of said first inputs (201,202,411,412,415,416,511,515) of said at least two mixer units (221,222,421,422,521,522,621,622).

8. The device according to claim 7, wherein at least one preamplifier of said at least one preamplifier (560,561,562,660,661,662) represents a wideband preamplifier and is connected to at least two of said first inputs (201,202,411,412,415, 416,511,515) of said at least two mixer units (221,222,421,422,521, 522,621,622).

9. The device according to any one of claims 1-8, comprising at least one filter (561,562,661,662) connected to at least one input of said first inputs (201,202, 411,412,415, 416,511,515) of said at least two mixer units (221,222,421,422, 521, 522,621,622).

10. The device according to claim 9, wherein at least one of said at least one filter (561,562,661,662) represents a band-pass filter (561,562,661,662).

11. The device according to any one of claims 1-10, wherein said at least two mixer units (521, 522,621,622) represent mixer units providing complex signal representations having a first and a second component, and wherein said at least one amplifier comprises a first amplifier (440,640) coupled to at least two outputs associated with said first component of said complex mixer units, and wherein said at least one amplifier comprises a second amplifier (445,645) coupled to at least two outputs associated with said second component of said complex mixer units.

12. The device according to any one of claims 1-11, wherein at least one mixer unit (300,421,422,521,522,622) of said at least two mixer units (221,222,421,422, 521,522,621,622) represents an image rejection mixer.

13. The device according to any one of claims 1-12, wherein at least one mixer unit (651) of said at least two mixer units (221,222,421,422,521,522,621,622) represents a harmonic rejection mixer.

14. A method, comprising:
- enabling (710) at least one mixer unit of at least two mixer units (221,222,421,422,521,522,621,622), wherein said at least two mixer units (221,222,421,422,521,522,621,622) arc associated with at least two different mixer frequencies, and wherein each of said mixer units comprises a first input configured to receive at least one input signal, and
- mixing (720) the received at least one input signal at said at least one enabled mixer unit to at least one output signal.
- amplifying (730) said at least one output signal by means of at least one amplifier (240,440,445,640,645), wherein said at least one amplifier (240,440,445,640,645) represents at least one transimpedance amplifier, and each of said at least one amplifier is coupled to at least two outputs of at least two different mixer units of said at least two mixer units (221,222,421,422,521,522,621,622).
- coupling said at least one amplifier (240,440,445,640,645) to said at least two outputs of said at least two mixer units (221,222,421,422,521, 522,621,622) by means of a bus (270,470,570,670), said bus (270,470,570,670) comprising a low-pass filter unit coupled to said bus (270,470,570,670) in order to filter unwanted or high frequency signals by providing a low-pass filtering, said low-pass filter unit ensuring that substantially all high-frequency currents injected to virtual ground nodes are filtered out and not converted into voltages.

15. A system, comprising:
- a device (200,400,400',500,500',600,600',600") according to any one of the claims 1-13; and
- a radio frequency unit configured to receive at least one radio frequency signal, wherein said radio frequency unit is coupled to said device (200,400,400',500,500', 600,600',600") in order to provide said at least one received radio frequency signal to said device.

## Patentansprüche

1. Eine Vorrichtung aufweisend:
zumindest zwei Mischereinheiten (221, 222, 421, 422, 521, 522, 621, 622), die mit zumindest zwei verschiedenen Mischerfrequenzen verknüpft sind, wobei jede der Mischereinheiten (221, 222, 421, 422, 521, 522, 621, 622) einen ersten Eingang (201, 202, 411,412,415,416,511,515) aufweist, der eingerichtet ist, um zumindest ein zu mischendes Eingangssignal zu empfangen,
zumindest einen Verstärker (240, 440, 445, 640, 645), wobei jeder des zumindest einen Verstärker (240, 440, 445, 640, 645) an zumindest zwei Ausgänge (231, 232) von zumindest zwei verschiedenen Mischereinheiten (221, 222, 421, 422, 521, 522, 621, 622) der zumindest zwei Mischereinheiten (221, 222, 421, 422, 521, 522, 621, 622) gekoppelt ist, wobei der zumindest eine Verstärker (240, 440, 445, 640, 645) zumindest einen Transimpedanzverstärker repräsentiert,
einen Bus (270, 470, 570, 670), der eingerichtet ist, um den zumindest einen Verstärker (240, 440, 445, 640, 645) an die zumindest zwei Ausgänge der zumindest zwei Mischereinheiten (221, 222, 421, 422, 521, 522, 621, 622) zu koppeln,
wobei der Bus (270, 470, 570, 670) eine Tiefpassfiltereinheit aufweist, die an den Bus (270, 470, 570, 670) gekoppelt ist, um unerwünschte oder Hochfrequenzsignale mittels eines Bereitstellens eines Tiefpassfilterns zu filtern, wobei die Tiefpassfiltereinheit sicherstellt, dass im Wesentlichen alle Hochfrequenzströme, die in virtuelle Masseknoten eingespeist werden, heraus gefiltert werden und nicht in Spannungen konvertiert werden.

2. Die Vorrichtung gemäß Anspruch 1, wobei zumindest eine der zumindest zwei Mischereinheiten (221, 222, 421, 422, 521, 522, 621, 622) eingerichtet ist, um aktiviert und/oder deaktiviert zu werden.

3. Die Vorrichtung gemäß irgendeinem der Ansprüche 1 bis 2, wobei jede der zumindest zwei Mischereinheiten (221, 222, 421, 422, 521, 522, 621, 622) einen zweiten Eingang (211, 212) aufweist, der eingerichtet ist, um zumindest ein lokal oszillierendes Signal zu empfangen, und wobei das zumindest eine lokal oszillierende Signal mit einer aus den zumindest zwei verschiedenen Mischerfrequenzen verknüpft ist.

4. Die Vorrichtung gemäß Anspruch 3, wobei zumindest eine Mischereinheit der zumindest zwei Mischereinheiten (221, 222, 421, 422, 521, 522, 621, 622) mit einem Treiber (251, 252, 451, 452, 551, 552, 651, 652) verknüpft ist, der mit dem zweiten Eingang (211, 212) der zumindest einen Mischereinheit (221, 222, 421, 422, 521, 522, 621, 622) verbunden ist, wobei der Treiber (251, 252, 451, 452, 551, 552, 651, 652) eingerichtet ist, um das zumindest eine lokal oszillierende Signal an der entsprechenden Mischereinheit (221, 222, 421, 422, 521, 522, 621, 622) bereitzustellen.

5. Die Vorrichtung gemäß Anspruch 4, wobei der Treiber (251, 252, 451, 452, 551, 552, 651, 652) eingerichtet ist, um die entsprechende Mischereinheit (221, 222, 421, 422, 521, 522, 621, 622) zu aktivieren und/oder zu deaktivieren.

6. Die Vorrichtung gemäß Anspruch 4, wobei der Treiber (251, 252, 451, 452, 551, 552, 651, 652) mit der entsprechenden Mischereinheit (221, 222, 421, 422, 521, 522, 621, 622) über eine alternierende Stromkopplung verbunden ist, und wobei eine Steuerleitung mit der alternierenden Stromkopplung verbunden ist, um die Mischereinheit (221, 222, 421, 422, 521, 522, 621, 622) zu aktivieren und/oder zu deaktivieren.

7. Die Vorrichtung gemäß irgend einem der Ansprüche 1 bis 6, aufweisend zumindest einen Vorverstärker (560, 561, 562, 660, 661, 662), der mit zumindest einem Eingang der ersten Eingänge (201, 202, 411, 412, 415, 416, 511, 515) der zumindest zwei Mischereinheiten (221, 222, 421, 422, 521, 522, 621, 622) verbunden ist.

8. Die Vorrichtung gemäß Anspruch 7, wobei zumindest ein Vorverstärker des zumindest einen Vorverstärkers (560, 561, 562, 660, 661, 662) einen Breitbandvorverstärker repräsentiert und mit zumindest zwei der ersten Eingänge (201, 202, 411, 412, 415, 416, 511, 515) der zumindest zwei Mischereinheiten (221, 222, 421, 422, 521, 522, 621, 622) verbunden ist.

9. Die Vorrichtung gemäß irgend einem der Ansprüche 1 bis 8, aufweisend zumindest einen Filter (561, 562, 661, 662), der mit zumindest einem Eingang der ersten Eingänge (201, 202, 411,412,415,416,511,515) der zumindest zwei Mischereinheiten (221, 222, 421, 422, 521, 522, 621, 622) verbunden ist.

10. Die Vorrichtung gemäß Anspruch 9, wobei zumindest einer des zumindest einen Filter (561, 562, 661, 662) einen Bandpassfilter (561, 562, 661, 662) repräsentiert.

11. Die Vorrichtung gemäß irgend einem der Ansprüche 1 bis 10, wobei die zumindest zwei Mischereinheiten (521, 522, 621, 622) Mischereinheiten repräsentieren, die komplexe Signalrepräsentationen bereitstellen, die eine erste und eine zweite Komponente haben, und wobei der zumindest eine Verstärker einen ersten Verstärker (440, 640) aufweist, der an zumindest zwei Ausgänge gekoppelt ist, die mit der ersten Komponente der komplexen Mischereinheiten verknüpft sind, und wobei der zumindest eine Verstärker einen zweiten Verstärker (445, 645) aufweist, der an zumindest zwei Ausgänge gekoppelt ist, die mit der zweiten Komponente der komplexen Mischereinheiten verknüpft sind.

12. Die Vorrichtung gemäß irgendeinem der Ansprüche 1 bis 11, wobei zumindest eine Mischereinheit (300, 421, 422, 521, 522, 622) der zumindest zwei Mischereinheiten (221, 222, 421, 422, 521, 522, 621, 622) einen Bildunterdrückungsmischer repräsentiert.

13. Die Vorrichtung gemäß irgendeinem der Ansprüche 1 bis 12, wobei zumindest eine Mischereinheit (651) der zumindest zwei Mischereinheiten (221, 222, 421, 422, 521, 522, 621, 622) einen harmonischen Unterdrückungsmischer repräsentiert.

14. Ein Verfahren aufweisend:
Aktivieren (710) zumindest einer Mischereinheit von zumindest zwei Mischereinheiten (221, 222, 421, 422, 521, 522, 621, 622), wobei die zumindest zwei Mischereinheiten (221, 222, 421, 422, 521, 522, 621, 622) mit zumindest zwei verschiedenen Mischerfrequenzen verknüpft sind, und wobei jede der Mischereinheiten einen ersten Eingang aufweist, der eingerichtet ist, um zumindest ein Eingangssignal zu empfangen, und
Mischen (720) des empfangenen zumindest einen Eingangssignals der zumindest einen aktivierten Mischereinheit zu zumindest einem Ausgangssignal,
Verstärken (730) des zumindest einen Ausgangssignals mittels zumindest eines Verstärkers (240, 440, 445, 640, 645), wobei der zumindest eine Verstärker (240, 440, 445, 640, 645) zumindest einen Transimpedanzverstärker repräsentiert und jeder des zumindest einen Verstärkers an zumindest zwei Ausgängen der zumindest zwei verschiedenen Mischereinheiten der zumindest zwei Mischereinheit (221, 222, 421, 422, 521, 522, 621, 622) gekoppelt ist,
Koppeln des zumindest einen Verstärkers (240, 440, 445, 640, 645) an die zumindest zwei Ausgänge der zumindest zwei Mischereinheiten (221, 222, 421, 422, 521, 522, 621, 622) mittels eines Busses (270, 470, 570, 670), wobei der Bus (270, 470, 570, 670) eine Tiefpassfiltereinheit aufweist, die an den Bus (270, 470, 570, 670) gekoppelt ist, um unerwünschte oder Hochfrequenzsignale mittels eines Bereitstellens eines Tiefpassfilterns zu filtern, wobei die Tiefpassfiltereinheit sicherstellt, dass im Wesentlichen alle Hochfrequenzströme, die in virtuelle Masseknoten eingespeist werden, heraus gefiltert werden und nicht in Spannungen konvertiert werden.

15. Ein System aufweisend:
eine Vorrichtung (200, 400, 400', 500, 500', 600, 600', 600") gemäß irgend einem der Ansprüche 1 bis 13, und
eine Radiofrequenzeinheit, die eingerichtet ist, um zumindest ein Radiofrequenzsignal zu empfangen, wobei die Radiofrequenzeinheit an die Vorrichtung (200, 400, 400', 500, 500', 600, 600', 600 ") gekoppelt ist, um das zumindest eine empfangene Radiofrequenzsignal an der Vorrichtung bereitzustellen.

## Revendications

1. Dispositif, comprenant :
- au moins deux unités de mélange (221, 222, 421, 422, 521, 522, 621, 622) correspondant à au moins deux fréquences de mélange différentes, dans lequel chacune desdites unités de mélange (221, 222, 421, 422, 521, 522, 621, 622) comporte une première entrée (201, 202, 411, 412, 415, 416, 511, 515) configurée pour recevoir au moins un signal d'entrée à mélanger,
- au moins un amplificateur (240, 440, 445, 640, 645), dans lequel chacun desdits amplificateurs (240, 440, 445, 640, 645) au nombre de un au moins est raccordé à au moins deux sorties (231, 232) de deux unités de mélange différentes (221, 222, 421, 422, 521, 522, 621, 622) au moins parmi lesdites deux unités de mélange (221, 222, 421, 422, 521, 522, 621, 622) au moins, dans lequel ledit amplificateur (240, 440, 445, 640, 645) au moins représente au moins un amplificateur transimpédance,
- un bus (270, 470, 570, 670) configuré de manière à raccorder ledit amplificateur (240, 440, 445, 640, 645) au moins auxdites deux sorties desdites deux unités de mélange (221, 222, 421, 422, 521, 522, 621, 622) au moins,
dans lequel ledit bus (270, 470, 570, 670) comporte une unité de filtre passe-bas raccordée audit bus (270, 470, 570, 670) pour filtrer les signaux indésirables ou haute fréquence en réalisant un filtrage passe-bas, ledit filtre passe-bas garantissant que pratiquement tous les courants haute fréquence injectés sur des noeuds de masse virtuelle sont éliminés et ne sont pas convertis en tensions.

2. Dispositif selon la revendication 1, 2, dans lequel au moins une parmi lesdites deux unités de mélange (221, 222, 421, 422, 521, 522, 621, 622) est configurée de manière à être activée et/ou désactivée.

3. Dispositif selon l'une quelconque des revendications 1-2, dans lequel chacune desdites au moins deux unités de mélange (221, 222, 421, 422, 521, 522, 621, 622) comporte une deuxième entrée (211, 212) configurée pour recevoir au moins un signal d'oscillation local, et dans lequel ledit signal d'oscillation local au moins est associé à une parmi lesdites deux fréquences différentes de mélange au moins.

4. Dispositif selon la revendication 3, dans lequel une unité de mélange parmi lesdites deux unités de mélange (221, 222, 421, 422, 521, 522, 621, 622) au moins est associée à un pilote (251, 252, 451, 452, 551, 552, 651, 652) raccordé à ladite deuxième entrée (211, 212) de ladite unité de mélange (221, 222, 421, 422, 521, 522, 621, 622) au moins, ledit pilote (251, 252, 451, 452, 551, 552, 651, 652) étant configuré de manière à fournir au moins un signal d'oscillation local à l'unité de mélange correspondante (221, 222, 421, 422, 521, 522, 621, 622).

5. Dispositif selon la revendication 4, dans lequel ledit pilote (251, 252, 451, 452, 551, 552, 651, 652) est configuré de manière à activer et/ou désactiver l'unité de mélange correspondante (221, 222, 421, 422, 521, 522, 621, 622).

6. Dispositif selon la revendication 4, dans lequel ledit pilote (251, 252, 451, 452, 551, 552, 651, 652) est raccordé à ladite unité de mélange correspondante (221, 222, 421, 422, 521, 522, 621, 622) par l'intermédiaire d'un couplage en courant alternatif, et dans lequel une ligne de commande est raccordée audit couplage en courant alternatif pour activer et/ou désactiver ladite unité de mélange (221, 222, 421,422,521,522,621,622).

7. Dispositif selon l'une quelconque des revendications 1 à 6, comprenant au moins un préamplificateur (560, 561, 562, 660, 661, 662) raccordé à au moins une entrée parmi lesdites premières entrées (201, 202, 411, 412, 415, 416, 511, 515) desdites deux unités de mélange (221, 222, 421, 422, 521, 522, 621, 622) au moins.

8. Dispositif selon la revendication 7, dans lequel au moins un préamplificateur parmi lesdits préamplificateurs (560, 561, 562, 660, 661, 662) au nombre de un au moins représente un préamplificateur large bande et est raccordé à au moins deux desdites premières entrées (201, 202, 411, 412, 415, 416, 511, 515) desdites deux unités de mélange (221, 222, 421, 422, 521, 522, 621, 622) au moins.

9. Dispositif selon l'une quelconque des revendications 1 à 8, comprenant au moins un filtre (561, 562, 661, 662) raccordé à au moins une entrée parmi lesdites premières entrées (201, 202, 411, 412, 415, 416, 511, 515) desdites deux unités de mélange (221, 222, 421, 422, 521, 522, 621, 622) au moins.

10. Dispositif selon la revendication 9, dans lequel ledit filtre (561, 562, 661, 662) au nombre de un au moins représente un filtre passe-bande (561, 562, 661, 662).

11. Dispositif selon l'une quelconque des revendications 1 à 10, dans lequel lesdites deux unités de mélange (521, 522, 621, 622) au moins représentent des unités de mélange fournissant des représentations de signal complexes ayant une première et une deuxième composante, et dans lequel ledit amplificateur au nombre de un au moins comporte un premier amplificateur (440, 640) raccordé à aux moins deux sorties correspondant auxdites premières composantes desdites unités de mélange complexes, et dans lequel ledit amplificateur au nombre de un au moins comporte un deuxième amplificateur (445, 645) raccordé à aux moins deux sorties correspondant auxdites deuxièmes composantes desdites unités de mélange complexes.

12. Dispositif selon l'une quelconque des revendications 1 à 11, dans lequel au moins une unité de mélange (300, 421, 422, 521, 522, 622) parmi lesdites deux unités de mélange (221, 222, 421, 422, 521, 522, 621, 622) au moins représente un mélangeur à réjection d'image.

13. Dispositif selon l'une quelconque des revendications 1 à 12, dans lequel au moins une unité de mélange (651) parmi lesdites deux unités de mélange (221, 222, 421, 422, 521, 522, 621, 622) au moins représente un mélangeur à réjection d'harmoniques.

14. Procédé, comprenant :
- l'activation (710) d'au moins une unité de mélange parmi au moins deux unités de mélange (221, 222, 421, 422, 521, 522, 621, 622), dans lequel lesdites deux unités de mélange (221, 222, 421, 422, 521, 522, 621, 622) au moins correspondent à au moins deux fréquences de mélange différentes, et dans lequel chacune desdites unités de mélange comporte une première entrée configurée pour recevoir au moins un signal d'entrée, et
- le mélange (720) du signal d'entrée reçu au moins sur ladite unité de mélange activée au moins en au moins un signal de sortie,
- l'amplification (730) dudit signal de sortie au moins à l'aide d'au moins un amplificateur (240, 440, 445, 640, 645), dans lequel ledit amplificateur (240, 440, 445, 640, 645) au nombre de un au moins représente au moins un amplificateur transimpédance, et dans lequel chacun desdits amplificateurs au nombre de un au moins est raccordé à au moins deux sorties de deux unités de mélange différentes au moins parmi les deux unités de mélange (221, 222, 421, 422, 521, 522, 621, 622) au moins,
- le couplage dudit amplificateur (240, 440, 445, 640, 645) au nombre de un au moins auxdites deux sorties desdites deux unités de mélange (221, 222, 421, 422, 521, 522, 621, 622) au moins à l'aide d'un bus (270, 470, 570, 670), ledit bus (270, 470, 570, 670) comportant une unité de filtre passe-bas raccordée audit bus (270, 470, 570, 670) pour filtrer les signaux indésirables ou haute fréquence en réalisant un filtrage passe-bas, ledit filtre passe-bas garantissant que pratiquement tous les courants haute fréquence injectés sur des noeuds de masse virtuelle sont éliminés et ne sont pas convertis en tensions.

15. Système, comprenant :
- un dispositif (200, 400, 400', 500, 500', 600, 600', 600") selon l'une quelconque des revendications 1 à 13 ; et
- une unité radiofréquence configurée de manière à recevoir au moins un signal radiofréquence, dans lequel ladite unité radiofréquence est raccordée audit dispositif (200, 400, 400', 500, 500', 600, 600', 600") pour fournir ledit signal radiofréquence au nombre de un au moins audit dispositif.
